# DEMANDE DE BREVET EUROPEEN

(11) **EP 1 624 493 A2**
(43) Date de publication de la demande: **08.02.2006**
(21) Numéro de dépôt: 05106673.6
(22) Date de dépôt: 20.07.2005
(51) Int. Cl.: H01L 31/0232, H01L 31/0203

(54) **Procédé de fabrication de module optique pour boîtier semiconducteur à capteur optique**

(30) Priorité: 23.07.2004 FR 0451640
(71) Demandeur: STMICROELECTRONICS SA, 92120 Montrouge (FR)
(72) Inventeur: Vigier-Blanc, Emmanuelle, 38700, Le Sappey en Chartreuse (FR)
(74) Mandataire: de Beaumont, Michel

(57) **Abrégé**

L'invention concerne un module optique comprenant un substrat en verre (6) portant un diaphragme (4) destiné à recevoir une lentille à base circulaire (3), la surface du diaphragme comportant en saillie un ou plusieurs éléments (9) de guidage en positionnement horizontal de la lentille, et son procédé de fabrication.

## Description

### Domaine de l'invention

La présente invention concerne le domaine des capteurs optiques associés à des dispositifs semiconducteurs et, plus particulièrement, la fabrication d'un boîtier semiconducteur à capteur optique et notamment du module optique de celui-ci.

De tels boîtiers semiconducteurs à module optique sont utilisés, par exemple, pour réaliser des caméras ou dispositifs de prise de vue miniatures, par exemple dans les téléphones portables.

### Exposé de l'art antérieur

Les modules optiques pour les dispositifs à capteur optique de boîtiers semiconducteurs sont essentiellement constitués d'une lentille hémisphérique rapportée sur un diaphragme placé à distance focale d'un réseau de microlentilles réalisé sur une puce de circuit intégré constituant le capteur optique.

Une première famille connue de modules optiques est constituée d'un capot en matière plastique rotatif destiné à suspendre la lentille et le diaphragme, et à être rapporté sur la puce de circuit intégré. La rotation du capot sert, notamment, à ajuster la distance focale, donc de dispositif de focus. Cette famille de modules optiques est généralement destinée à des lentilles réalisées en matière plastique dont les tolérances de positionnement et de fabrication (de l'ordre de plus ou moins 80 micromètres) sont incompatibles avec la faible distance focale (quelques millimètres) de ce genre de dispositif.

Une deuxième famille connue de modules optiques consiste à utiliser une lentille en verre (généralement hémisphérique) rapportée sur un diaphragme réalisé sur un espaceur en verre, lui-même reposant sur la puce de circuit intégré portant les microcapteurs (phototransistors, microdiaphragmes et microlentilles) . La présente invention s'applique plus particulièrement à cette famille de modules optiques.

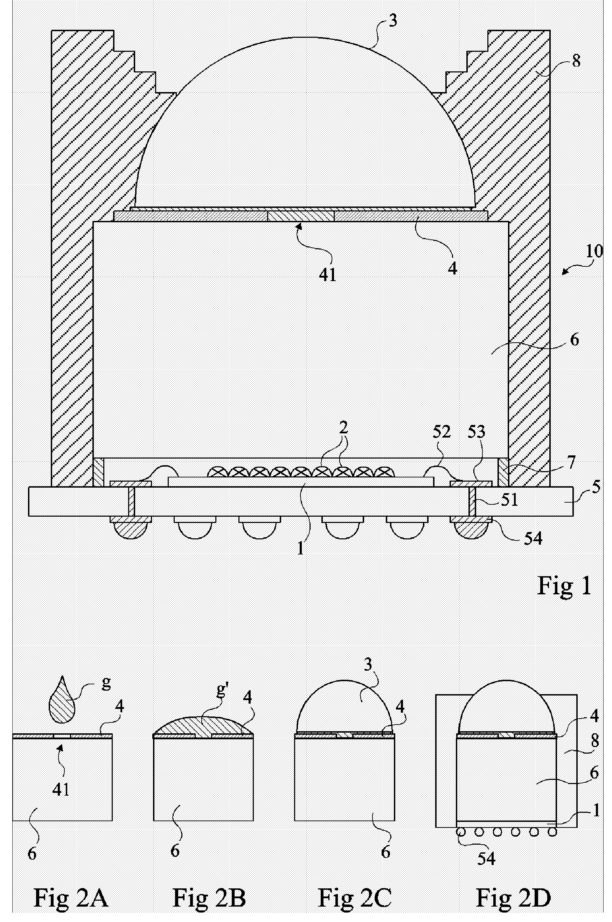

La figure 1 représente un exemple classique de boîtier semiconducteur à capteur optique tel que décrit dans la demande de brevet français 03/12305 (03/GR2/190) de la demanderesse.

Un tel boîtier 10 constituant un élément de prise de vue comporte une puce 1 de circuit intégré constituant un capteur optique, sur laquelle ont été représentées des microlentilles 2 hémisphériques. En pratique, ces microlentilles sont intégrées dans le silicium de la puce 1 au-dessus des phototransistors.

Le boîtier 10 comporte également une lentille 3 disposée à distance de la puce 1 et un diaphragme 4 contre la face inférieure (en regard du capteur) de la lentille 3. Un espaceur en verre 6, relativement épais (de l'ordre de quelques millimètres) par rapport à l'épaisseur de la puce 1, est intercalé entre la puce 1 et le diaphragme 4 et définit la distance focale du dispositif optique. L'ensemble décrit ci-dessus est réalisé par lot en plaques entières avant d'être découpé pour individualisation. L'ensemble repose alors sur un substrat 5. Les informations électriques fournies par la puce 1 de circuit intégré sont reportées, par exemple, depuis la surface supérieure de cette puce portant les microlentilles 2 au moyen de fils 52 de reprise de contact vers des plots 53 en face supérieure du substrat, les plots 53 étant connectés électriquement à des plots 54 en face arrière (libre) du substrat 5 par l'intermédiaire de via 51 dans son épaisseur. Les plots 54 reçoivent alors généralement des billes ou bossages conducteurs 55 pour montage du boîtier semiconducteur sur un circuit imprimé à la manière d'un boîtier BGA (Ball Grid Array).

En pratique, l'espaceur 6 est obtenu au moyen d'une plaquette en verre contre les faces respectives de laquelle sont rapportées d'une part une grille de diaphragmes 4 et une plaquette de lentille 3 et d'autre part les puces de circuit intégré 1 portées par les substrats 5, une entretoise 7 d'épaisseur relativement faible par rapport à l'épaisseur de l'espaceur 6 étant prévue pour éviter que la puce 1 touche l'espaceur 6 et soit endommagée lors de l'assemblage.

Dans l'exemple de la figure 1, on suppose que l'optique 3 est constituée d'une lentille hémisphérique en verre. En variante, la courbure définitive de la lentille de focalisation peut être adaptée en plongeant la lentille hémisphérique dans une cavité contenant une résine optique qui polymérise par un procédé de réplication, afin de rapporter une couche de surface (non représentée) lui donnant la courbure souhaitée.

Une fois que les dispositifs, constitués de la puce 1 portée par le substrat 5, de l'espaceur 6 et de l'optique 4, ont été individualisés, un carter 8 généralement en matière plastique (résine) est rapporté autour de l'ensemble pour protéger le système et pour terminer le boîtier 10.

Les figures 2A à 2D illustrent le montage classique de la lentille hémisphérique 3 sur le diaphragme 4, porté par l'espaceur en verre 6. Ce montage est généralement effectué après découpe des circuits intégrés 1 et des espaceurs 6 portant les diaphragmes 4.

Une première étape (figure 2A) consiste à déposer une goutte g de colle sur le diaphragme 4 porté par l'espaceur 6.

La colle s'étale sur le diaphragme (figure 2B) et remplit l'ouverture 41 de celui-ci. On obtient une couche g' de colle sur la structure.

On rapporte ensuite (figure 2C) une lentille hémisphérique en verre 3 sur la couche de colle g' et on soumet l'ensemble à un traitement ultraviolet afin de faire polymériser la colle. La colle est choisie pour être thixotrope c'est-à-dire sans effet capillaire, afin de ne pas remonter sur la lentille ce qui modifierait ses propriétés optiques.

Enfin (figure 2D), le circuit intégré 1 est rapporté sur la face arrière de l'espaceur 6 en verre, les bossages conducteurs 54 sont formés en face arrière et l'ensemble du module est surmonté d'une matière plastique pour former le carter 8.

Un problème de l'assemblage ainsi réalisé est que, lorsque la lentille 3' est posée sur la couche de colle g' non solidifiée, elle flotte sur cette dernière, ce qui augmente considérablement les tolérances en positionnement horizontal. Ce phénomène est particulièrement marqué lorsqu'on cherche à assembler les lentilles sur plaquettes entières. Un inconvénient est que cela engendre des problèmes de résolution.

Dans certains cas, les diaphragmes 4 sont formés d'une grille métallique rapportée sur la plaquette de verre constituant les espaceurs 6. Dans un tel cas, on assiste à un problème supplémentaire de décalage horizontal des grilles métalliques par rapport aux centres des lentilles. De plus, les tolérances de gravure des ouvertures 41 dans ces grilles sont supérieures (de l'ordre de plus ou moins 5 micromètres) par rapport aux tolérances dans le diamètre des lentilles (plus ou moins 3 micromètres pour un diamètre de l'ordre de 3 millimètres).

Le flottement de la lentille sur le matelas de colle reste cependant le plus critique car il ajoute une tolérance bien plus grande, de l'ordre de plus ou moins 100 micromètres.

### Résumé de l'invention

La présente invention vise à pallier les inconvénients des assemblages classiques de lentilles hémisphériques sur des diaphragmes de modules optiques miniaturisés.

L'invention vise notamment à proposer un procédé d'assemblage qui optimise le centrage des lentilles par rapport aux centres des ouvertures des diaphragmes et aux centres des capteurs.

La présente invention vise également à proposer une solution qui améliore le nombre d'étapes qu'il est possible d'effectuer par lot sur des plaquettes entières.

Pour atteindre ces objets ainsi que d'autres, la présente invention prévoit un procédé de fabrication d'un module optique d'un boîtier semiconducteur à capteur optique, consistant :
à déposer, sur une face avant d'une plaquette de verre dont l'épaisseur est choisie pour former un espaceur entre le capteur optique et une lentille de focalisation à base circulaire, une couche métallique opaque ;
à graver cette couche selon un motif de définition d'ouvertures de diaphragmes entre la lentille et le capteur, et un ou plusieurs éléments de guidage en périphérie d'un cercle dans lequel s'inscrit la base de la lentille à rapporter sur le diaphragme ; et
à découper la plaquette pour individualiser des modules optiques sur lesquels sont rapportées lesdites lentilles positionnées grâce auxdits éléments de guidage.

Selon un mode de mise en oeuvre de la présente invention, une face avant d'une plaquette contenant les capteurs optiques est rapportée, avant découpe, sur une face arrière de la plaquette en verre.

Selon un mode de mise en oeuvre de la présente invention, des bossages conducteurs de raccordement électrique sont réalisés, avant découpe, en face arrière de la plaquette portant les capteurs optiques.

Selon un mode de mise en oeuvre de la présente invention, un carter de maintien définitif est rapporté autour du module.

Selon un mode de mise en oeuvre de la présente invention, le maintien temporaire de la lentille sur le diaphragme s'effectue par adhésion moléculaire.

La présente invention prévoit également un module optique comprenant un substrat en verre portant un diaphragme destiné à recevoir une lentille à base circulaire, la surface du diaphragme comportant en saillie un ou plusieurs éléments de guidage en positionnement horizontal de la lentille.

Selon un mode de réalisation de la présente invention, au moins trois éléments ponctuels sont répartis en périphérie d'un cercle dans lequel s'inscrit la base circulaire de la lentille.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1, 2A, 2B, 2C et 2D qui ont été décrites précédemment, sont destinées à exposer l'état de la technique et le problème posé ;
les figures 3A, 3B et 3C illustrent, de façon très schématique par des vues en coupe, un mode de mise en oeuvre du procédé d'assemblage selon la présente invention, sur un module optique individuel ;
les figures 4 et 5 sont des vues de dessus de mode de réalisations de diaphragmes pourvus d'éléments de positionnement selon l'invention ; et
les figures 6A, 6B et 6C illustrent des étapes caractéristiques du procédé de fabrication de boîtiers semiconducteurs à capteur optique selon la présente invention.

### Description détaillée

Par souci de clarté, de mêmes éléments ont été désignés par de mêmes références aux différentes figures. De plus, comme cela est habituel dans la représentation des circuits intégrés, les diverses figures ne sont pas tracées à l'échelle. En outre, seuls les éléments et étapes utiles à la compréhension de l'invention ont été représentés et seront décrits par la suite. En particulier, la fabrication de la puce de circuit intégré constituant le capteur à microlentilles proprement dit n'a pas été détaillée, l'invention étant compatible avec tout capteur classique. De plus, les étapes qui sont dérivées de procédés couramment utilisés dans la technologie de fabrication de semiconducteur n'ont pas été détaillées et sont accessibles à l'homme du métier sans difficulté.

Une caractéristique de la présente invention est de prévoir, dans la couche constitutive du diaphragme ou dans une couche rapportée sur celle-ci, un guide de positionnement des lentilles hémisphériques.

De préférence, les lentilles déposées sur les diaphragmes sont maintenues temporairement par collage moléculaire avant qu'elles soient maintenues définitivement par le carter du module.

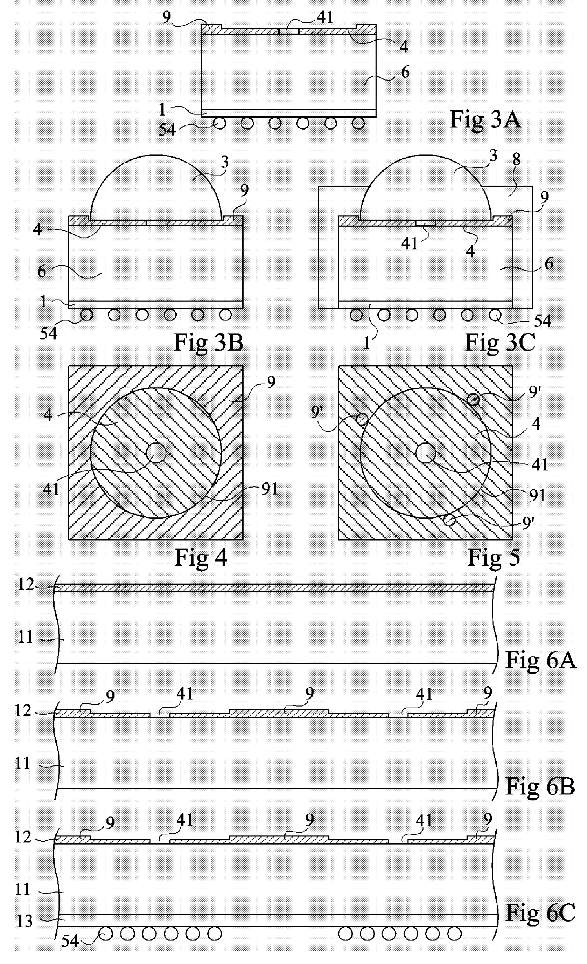

Les figures 3A, 3B et 3C illustrent, de façon très schématique, la structure d'un module individuel selon l'invention au cours de son assemblage.

L'assemblage d'une lentille 3 (figure 3B) hémisphérique sur un diaphragme 4 porté par un espaceur en verre 6 selon l'invention est effectué sur une structure telle que représentée en figure 3A dans laquelle un ou plusieurs éléments 9 de guidage horizontal de la lentille sont saillants par rapport à la surface du diaphragme 4.

Une fois les lentilles positionnées, un carter 8 est rapporté de façon classique et on obtient le boîtier semiconducteur à capteur optique.

On aurait pu penser améliorer le positionnement des lentilles en les plaçant temporairement dans une grille de positionnement. Cette solution est toutefois inapplicable car cela poserait d'une part un problème de tenue temporaire de la grille et d'autre part engendrerait un risque de rayure ou de décoller les hémisphères constituant les lentilles lorsque l'on souhaiterait ôter cette grille.

La figure 4 illustre, par une vue de dessus d'un diaphragme 4, un premier mode de réalisation de moyens de guidage selon l'invention. Il s'agit d'un changement de section circulaire (cercle 91) continu dont le diamètre intérieur est légèrement supérieur au diamètre de la surface hémisphérique de la lentille 3. Par légèrement supérieur, on entend un diamètre permettant l'engagement de cette lentille sans toutefois que le jeu de la lentille soit supérieur aux tolérances de positionnement souhaitées (quelques micromètres). Ce jeu doit être compatible avec les tolérances de fabrication de la lentille hémisphérique en verre (par exemple, plus ou moins trois micromètres pour une lentille de trois millimètres de diamètre). L'élément 9 de guidage est donc constitué du pourtour du cercle 91 dans lequel s'inscrit la lentille. Pour illustrer le changement de plan dans le diaphragme 4, des hachures différentes ont été utilisées pour les deux plans différents autour de l'ouverture 41.

La hauteur de l'élément saillant 9 par rapport au plan du diaphragme est par exemple, compris entre 50 et 100 micromètres.

La figure 5 illustre, par une vue de dessus d'un diaphragme 4', un deuxième mode de réalisation préféré de moyens de guidage selon l'invention. Il s'agit de plots localisés 9' saillants de la surface du diaphragme 4. Le nombre de plots 9' est au minimum de 3. Ces plots sont positionnés autour d'un cercle imaginaire 91 à l'intérieur duquel doit être positionnée une lentille 3.

Selon un mode de mise en oeuvre préféré, la tenue de la lentille 3 sur la surface du diaphragme 4 est temporairement assurée par collage moléculaire. Cette adhésion moléculaire est rendue possible par le fait que la surface de la lentille 3 est polie pour des raisons optiques et que la surface supérieure du diaphragme 4 présente un état de surface de type optique, obtenu par attaque chimique, en utilisant des techniques habituelles dans la fabrication de semiconducteurs.

La présente invention tire alors profit du fait que, pour préserver le fonctionnement optique du dispositif, les surfaces en regard du diaphragme et de la lentille ont besoin d'être le plus planes possible, de façon à obtenir un joint plein. Une telle planéité permet précisément d'obtenir une adhésion moléculaire.

Pour que le joint soit plein sous toute la surface de la lentille, la couche métallique du diaphragme sera préférentiellement formée directement sur la plaquette de verre dans laquelle auront été préalablement réalisés des îlots destinés à former par la suite les ouvertures 41 dans la couche opaque.

Le collage moléculaire obtenu est suffisant pour permettre une manipulation des modules jusqu'à leur positionnement dans un moule de formation du carter 8 qui assure la fixation définitive.

Dans le mode de réalisation de la figure 5, une faible quantité de colle peut être utilisée à la place de l'adhésion moléculaire. On préférera toutefois supprimer une étape de collage temporaire dans le procédé de fabrication.

Dans le mode de réalisation de la figure 4, on évitera d'utiliser de la colle, car elle risquerait de remonter par effet capillaire le long de la surface de la lentille.

Les figures 6A, 6B et 6C illustrent, de façon très schématique et simplifiée, un mode de mise en oeuvre du procédé de fabrication de boîtiers semiconducteurs à capteur optique selon l'invention.

On part (figure 6A) d'une plaque en verre 11 sur laquelle on dépose pleine plaque (en une ou plusieurs étapes) une couche métallique 12. L'épaisseur de la couche 12 est choisie pour être supérieure à l'épaisseur finale souhaitée pour les éléments de guidage ou pré-positionnement 9 (ou 9').

La couche 12 est ensuite gravée selon des motifs de définition des ouvertures 41 des diaphragmes et des éléments 9 ou 9' de guidage (figure 6B). Cette gravure utilise des techniques habituelles de photogravure (à l'aide de dépôt de couches photosensibles). Plusieurs étapes de gravure successives seront le cas échéant nécessaires selon les techniques utilisées.

La plaque ainsi réalisée est rapportée (figure 6C) sur une plaquette 13 de circuits intégrés contenant les capteurs proprement dits. Cette plaque est réalisée de façon classique et comporte en particulier le réseau de phototransistors. En figure 6C ont été représentés également les bossages conducteurs 54 du boîtier fini. En effet, l'invention est compatible avec la réalisation par plaquette entière de ces bossages 54. A l'issue des étapes représentées en figure 6C, les modules optiques sont individualisés par des moyens de découpe classiques, par exemple à la scie, à l'eau ou au laser. On retrouve alors les structures représentées en figure 3A sur lesquelles sont rapportées ensuite les lentilles hémisphériques (figure 3B), et qui sont moulées dans un carter 8 (figure 3C).

Dans le cas où la tenue temporaire de la lentille 3 est effectuée par adhésion moléculaire, il peut être nécessaire d'effectuer une étape de gravure supplémentaire au début du procédé afin de prévoir que les ouvertures 41 des diaphragmes 4 soit formées par des plots ou îlots en verre ou en résine et assurer ainsi la jonction pleine entre la lentille et le diaphragme.

Selon un autre mode de mise en oeuvre, on utilise une faible quantité de colle thixotrope pour tenir la lentille et remplir l'espace de l'ouverture du diaphragme. Comme indiqué précédemment, ce mode de mise en oeuvre est toutefois préférentiellement dédié au cas où les éléments de maintien temporaire sont ponctuels de façon à éviter de piéger la colle, ce qui entraînerait une remontée de celle-ci sur les bords de la lentille 3.

Un avantage de la présente invention est qu'elle résout les problèmes de positionnement horizontal des lentilles hémisphériques sur des modules optiques de faible dimension.

Un autre avantage de l'invention est qu'elle optimise le nombre d'étapes de fabrication qui peuvent être faites par plaquettes entières. En particulier, et bien que cela ne soit pas obligatoire, le traitement par plaquette entière peut aller jusqu'à la réalisation des bossages conducteurs en face arrière.

Un autre avantage de l'invention est qu'elle est compatible avec les autres étapes de fabrication classiques de dispositifs semiconducteurs à capteurs optiques et notamment avec la réalisation du capteur à phototransistors proprement dit.

Bien entendu, la présente invention est susceptible de diverses variantes et modifications qui apparaîtront à l'homme de l'art. En particulier, les dimensions à donner aux éléments de maintien temporaire 9 ou 9' et le jeu du cercle 91 autour duquel ils s'inscrivent pour le positionnement de la lentille sont à la portée de l'homme du métier en fonction des tolérances de fabrication des lentilles elles-mêmes. De plus, bien que l'invention ait été décrite en relation avec des lentilles hémisphériques, elle s'applique à des lentilles de courbure différente pourvu qu'elles aient une base circulaire.

## Revendications

1. Procédé de fabrication d'un module optique d'un boîtier semiconducteur à capteur optique, **caractérisé en ce qu'**il consiste :
à déposer, sur une face avant d'une plaquette de verre (11) dont l'épaisseur est choisie pour former un espaceur (6) entre le capteur optique (1) et une lentille de focalisation (3) à base circulaire, une couche métallique opaque (12) ;
à graver cette couche selon un motif de définition d'ouvertures (41) de diaphragmes (4) entre la lentille et le capteur, et un ou plusieurs éléments (9, 9') de guidage en périphérie d'un cercle (91) dans lequel s'inscrit la base de la lentille à rapporter sur le diaphragme ; et
à découper la plaquette pour individualiser des modules optiques sur lesquels sont rapportées lesdites lentilles positionnées grâce auxdits éléments de guidage.

2. Procédé selon la revendication 1, dans lequel une face avant d'une plaquette (13) contenant les capteurs optiques est rapportée, avant découpe, sur une face arrière de la plaquette en verre (11).

3. Procédé selon la revendication 2, dans lequel des bossages conducteurs (54) de raccordement électriques sont réalisés, avant découpe, en face arrière de la plaquette (13) portant les capteurs optiques.

4. Procédé selon l'une quelconque des revendications 1 à 3, dans lequel un carter (8) de maintien définitif est rapporté autour du module.

5. Procédé selon l'une quelconque des revendications 1 à 4, dans lequel le maintien temporaire de la lentille (3) sur le diaphragme s'effectue par adhésion moléculaire.

6. Module optique comprenant un substrat en verre (6) portant un diaphragme (4) destiné à recevoir une lentille à base circulaire (3), **caractérisé en ce que** la surface du diaphragme comporte en saillie un ou plusieurs éléments (9, 9') de guidage en positionnement horizontal de la lentille.

7. Module selon la revendication 6, comportant au moins trois éléments ponctuels (9') répartis en périphérie d'un cercle (91) dans lequel s'inscrit la base circulaire de la lentille (3).

8. Module selon la revendication 6 ou 7, obtenu par la mise en oeuvre du procédé selon l'une quelconque des revendications 1 à 5.
